# EUROPÄISCHE PATENTSCHRIFT

(11) **EP 1 740 033 B1**
(45) Veröffentlichungstag und Bekanntmachung des Hinweises auf die Patenterteilung: **27.10.2010**
(21) Anmeldenummer: 06007485.3
(22) Anmeldetag: 10.04.2006
(51) Int. Cl.: H05K 7/14, H03K 17/96, H05K 5/00

(54) **Elektronisches Steuergerät für elektrische Geräte**
Electronic controller for electric apparatus
Appareil de commande électronique pour des appareils électriques

(30) Priorität: 28.06.2005 DE 102005029915
(43) Veröffentlichungstag der Anmeldung: 03.01.2007
(73) Patentinhaber: Siebe Appliance Controls GmbH, 78559 Gosheim (DE)
(72) Erfinder: Anders, Klaus, 78559 Gosheim (DE); Bernhard, Heinz, 78559 Gosheim (DE); Weinmann, Bernhard, 78559 Gosheim (DE)
(74) Vertreter: Vetter, Hans

(56) Entgegenhaltungen:
- EP-A- 0 029 770
- EP-A- 1 672 797
- DE-A1- 2 806 112
- FR-A- 2 779 889

## Beschreibung

Die Erfindung betrifft ein elektronisches Steuergerät für elektrische Geräte, mit einem Gehäuse, das wenigstens eine elektronische Bauelemente aufweisende Leiterplatte enthält und mit einer ersten Gehäusewandung im Gebrauchszustand an einer isolierenden Abdeckplatte anliegt oder beabstandet von dieser positioniert ist, und mit wenigstens einem berührungssensitiven kapazitiven Bedienungselement, das ein zwischen einer Kontaktfläche der Leiterplatte und der Abdeckplatte elastisch klemmendes elektrisch leitfähiges Verbindungselement besitzt, wobei die der Anlagefläche des Verbindungselements an der Abdeckplatte gegenüberliegende Außenfläche der Abdeckplatte die berührungssensitive Bedienungsfläche des Bedienungselements bildet.

Bei einem derartigen, aus der EP 0 859 467 B1 bekannten Steuergerät besitzt das berührungssensitive Bedienungselement ein tonnenartiges Verbindungselement aus leitfähigem Kunststoffmaterial, dessen Länge ungefähr dem Durchmesser entspricht und das an einer entsprechenden Kontaktfläche der Leiterplatte angeklebt ist.

Nachteilig an der bekannten Anordnung ist zum einen der relativ große Platzbedarf des verbindungselements, das eine entsprechend große Kontaktfläche an der Leiterplatte erforderlich macht. Vor allem bei kleineren Gehäusen und mehreren Bedienungselementen kann dies zu Platzproblemen führen. Weiterhin ist das Gehäuse an seiner der Abdeckplatte zugewandten Seite nicht abgedichtet und kann auf Grund der kurzen und dicken Verbindungselemente auch nicht bei vernünftigem Aufwand abgedichtet werden. Darüber hinaus sind die großvolumigen Verbindungselemente aus leitfähigem Kunststoffmaterial sehr kostenaufwändig.

Aus der EP-A-0 029 770 ist ein berührungssensitives kapazitives Bedienungselement in Form von zwei Nieten, die über eine Feder miteinander verbunden sind, bekannt. Die beiden Nietköpfe dieses Bedienungselements liegen an gegenüberliegenden Seiten von zwei beabstandet voneinander angeordneten isolierten Blechplatten an. Dieses Bedienungselement eignet sich nicht als elastisch klemmendes Verbindungselement zwischen einer ein Gehäuse überdeckenden Abdeckplatte und einer Leiterplatte.

Ein aus der EP 1 672 797 A2 bekannter kapazitiver Berührungsschalter besitzt ein elastisch klemmendes Verbindungselement als Bedienungselement zwischen einer Abdeckplatte und einer Leiterplatte im Innern des Gehäuses.

Eine Aufgabe der vorliegenden Erfindung besteht darin, das aus EP 0 859 467 B1 bekannte Steuergerät so zu verbessern, dass bei geringerem Materialaufwand für die Verbindungselemente eine Gehäuseabdichtung auf der die Bedienungselemente aufweisenden Gehäuseseite erreicht wird.

Diese Aufgabe wird erfindungsgemäß durch ein Steuergerät mit den Merkmalen des Anspruchs 1 gelöst.

Die Vorteile des erfindungsgemäßen Steuergeräts bestehen insbesondere darin, dass in Folge der Haltekanäle die Verbindungselemente als dünne Stäbe bei sehr geringem Materialaufwand ausgebildet werden können. Der Haltekanal stützt und positioniert dabei die Verbindungselemente, so dass auch ein Ankleben an der Leiterplatte nicht erforderlich ist. In Folge der elastischen, durch die Haltekanäle des Gehäuses verlaufende Verbindungselemente kann auch in einfacher Weise eine Abdichtung des Gehäuses an dieser Stelle erreicht werden. Bin besonderer Vorteil besteht noch darin, dass bisherige bekannte, mit derartigen Haltekanälen versehene Gehäuse, die mechanische Schalter aufweisen, ohne Veränderung des Gehäuses leicht auf berührungssensitive Bedienungselemente umgerüstet werden können, bzw. diese Gehäuse können sowohl für berührungssensitive Schalter, wie auch für mechanische Schalter wahlweise eingesetzt werden. Zur Umrüstung müssen lediglich mechanische Schalter an der Leiterplatte durch Kontaktflächen ersetzt werden, die Betätigungsstifte für den mechanischen Schalter müssen durch elastisch klemmende elektrisch leitfähige Verbindungselemente ersetzt werden, und die Abdeckplatte braucht keine Durchgangsbohrungen zur Schalterbetätigung mehr aufweisen.

Durch die in den Unteransprüchen aufgeführten Maßnahmen sind vorteilhafte Weiterbildungen und Verbesserungen des im Anspruch 1 angegebenen Steuergeräts möglich.

Das Verbindungselement ist zweckmäßigerweise im nicht an der Abdeckplatte montierten Zustand im Haltekanal in einer zur Platinenebene senkrechten Richtung verschiebbar ausgebildet, was zum einen eine schnelle und einfache Montage ermöglicht und zum anderen im zwischen Kontaktfläche und Abdeckplatte eingeklemmten Zustand einen sicheren Kontakt gewährleistet. In einer zweckmäßigen ersten Ausgestaltung besteht das elastisch ausgebildete Verbindungselement aus leitfähigem Kunststoffmaterial, insbesondere aus leitfähigem Silikon. Dabei kann es zur Erzielung der Elastizität auch wenigstens teilweise schraubenfederartig oder zickzackförmig ausgebildet sein und kann dann aus härterem leitfähigem Kunststoffmaterial bestehen.

Nach einer weiteren zweckmäßigen Ausgestaltung besitzt das Verbindungselement einen stabförmigen Bereich aus einem harten leitfähigen Kunststoffmaterial oder aus Metall, der wenigstens an einem Ende mit einem federnden Anlagebereich versehen ist oder an einem solchen mündet, wobei dieser Anlagebereich als Druckfeder oder als elastisches leitfähiges Kunststoffteil ausgebildet ist.

Der stabförmige Bereich des Verbindungselements ist zweckmäßigerweise zylindrisch ausgebildet und besitzt vorzugsweise einen ringnutartigen Teilbereich, in den ein Gegenbereich des Haltekanals eingreift. Dies verhindert bei der Vormontage ein Herausfallen des Verbindungselements bzw. der Verbindungselemente.

Das elastische Kunststoffteil ist zweckmäßigerweise zwischen dem stabförmigen Bereich des Verbindungselements und der Kontaktfläche der Leiterplatte angeordnet und eine besonders einfache Montage ergibt sich dadurch, dass mehrere solcher elastisch leitfähigen Kunststoffteile für nebeneinander angeordnete Bedienungselemente bandartig miteinander verbunden sind, wobei die Verbindungsbereiche aus nicht leitfähigem Kunststoffmaterial bestehen. Somit können alle diese miteinander verbundene Kunststoffteile in einem Arbeitsgang an der Leiterplatte angebracht bzw. eingesetzt werden.

In einer weiteren zweckmäßigen Ausgestaltung kann das Verbindungselement auch als metallisches Druckfederelement ausgebildet sein und insbesondere eine Schraubenfeder- oder Zickzackform besitzen.

Der scheibenartige Anlagebereich kann in einer Ausbildung aus elastischem leitfähigem Material bestehen und tellerartig ausgebildet sein, um eine gute Anlage an der Abdeckplatte zu gewährleisten.

Der mit dem Verbindungselement versehene Haltekanal ist zweckmäßigerweise zur Abdichtung des Gehäuses gegen Staub und/oder Feuchtigkeit ausgebildet, wobei bei einer Ausbildung des Verbindungselements aus elastischem Material eine besonders gute Abdichtung erreicht wird.

Der wenigstens eine Haltekanal des Gehäuses ist zweckmäßigerweise auch zur wahlweisen Aufnahme auch eines stabförmigen Auslöseelements für einen elektrischen Schalter an der Leiterplatte ausgebildet.

Die erfindungsgemäße Ausbildung des Steuergeräts eignet sich besonders als Zeitschaltgerät, jedoch sind auch andere Ausbildungen von Steuergeräten möglich.

Der wenigstens eine Haltekanal ist zweckmäßigerweise einstükkig in aus einem Kunststoffmaterial bestehenden Gehäuse angeformt, was eine einfache und kostengünstige Fertigung und eine gute Abdichtung des Gehäuses ermöglicht.

Eine besonders günstige elektrische Ausbildung des berührungssensitiven Bedienungselements besteht darin, dass das einen Pol des Kondensators bildende Verbindungselement mit einer zyklisch eine Ladespannung anlegenden Ladestromquelle verbunden ist, wobei die jeweils erreichte und gemessene Kondensatorspannung das Kriterium darstellt, ob ein Finger einer Bedienungsperson als zweiter Pol des Kondensators an der Bedienungsfläche anliegt.

Ausführungsbeispiele der Erfindung sind in der Zeichnung dargestellt und in der nachfolgenden Beschreibung näher erläutert. Es zeigen:
- Figur 1: eine Längsschnittdarstellung des Gehäuses des Steuergeräts mit Verbindungselementen der berührungssensitiven Bedienungselemente, die teilweise schraubenfederartig ausgebildet sind, als erstes Ausführungsbeispiel der Erfindung,
- Figur 2: dasselbe Ausführungsbeispiel, bei dem das Gehäuse an einer Abdeckplatte angebracht ist,
- Figur 3: eine Vorderansicht des hinter der Abdeckplatte angeordneten Gehäuses,
- Figur 4: dasselbe Gehäuse mit Verbindungselementen, die aus elastischem, leitfähigem Kunststoffmaterial bestehen, als zweites Ausführungsbeispiel der Erfindung,
- Figur 5: dasselbe Gehäuse mit Verbindungselementen, die einen als Druckfeder ausgebildeten federnden Anlagebereich besitzen als drittes Ausführungsbeispiel der Erfindung,
- Figur 6: dasselbe Gehäuse mit Verbindungselementen, deren federnder Anlagebereich als elastisches leitfähiges Kunststoffteil ausgebildet ist, als viertes Ausführungsbeispiel der Erfindung,
- Figur 7: mehrere solcher Kunststoffteile, die bandartig miteinander verbunden sind,
- Figur 8: ein Schaltbild zur Erläuterung der Wirkungsweise eines berührungssensitiven Bedienungselements und
- Figur 9: ein Signaldiagramm zur Erläuterung der Spannungs- und Stromverläufe.

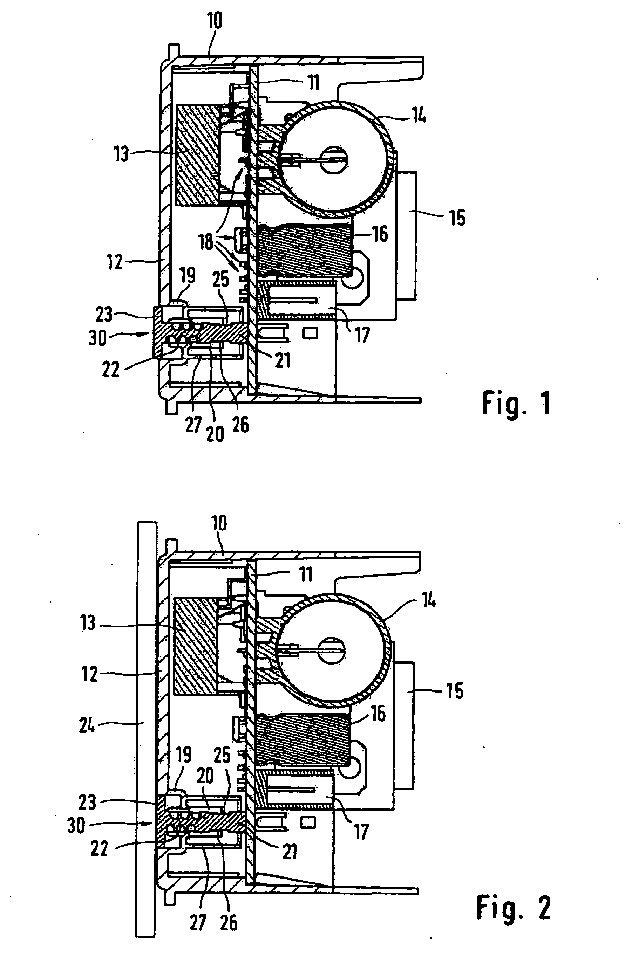

Bei dem in den Figuren 1 bis 3 dargestellten ersten Ausführungsbeispiel enthält ein Gehäuse 10 aus Kunststoffmaterial eine Leiterplatte 11, die parallel und beabstandet zur Frontwandung 12 des Gehäuses 10 angeordnet ist. Das elektronische Steuergerät ist beispielsweise als Herdschaltuhr ausgebildet, jedoch sind auch andere Anwendungen zur Steuerung von elektrischen Geräten möglich, beispielsweise von Kühlschränken, Waschmaschinen, Wäschetrocknern und dergleichen. Auch ist die Anwendung nicht auf Haushaltsgeräte beschränkt, sondern ist überall dort möglich, wo zeitabhängige oder sonstige Schaltvorgänge ausgeführt werden sollen.

An der Leiterplatte 11 sind die für die Steuerfunktionen, insbesondere Zeitsteuerfunktionen, erforderlichen elektrischen und elektronischen Bauteile angeordnet. An der zur Frontwandung 12 hinweisenden Seite der Leiterplatte 11 ist ein Display 13 angeordnet, das unmittelbar bis zur Frontwandung 12 reicht, die wenigstens an dieser Stelle durchsichtig ausgebildet sein muss, damit das Display 13 von außen abgelesen werden kann. An der Rückseite der Leiterplatte 11 befindet sich ein Tonsignalelement 14, ein Transformator 15, ein großer Kondensator 16 und ein Steckanschluss 17. Diese hinsichtlich ihrer Größe hervorstechenden Bauteile wurden lediglich beispielhaft aufgeführt, während die Vielzahl der kleineren Bauteile 18 nicht im Einzelnen erläutert wird, da sie für die vorliegende Erfindung von untergeordneter Bedeutung sind. Die erforderlichen Steuerfunktionen können entweder durch diskrete Bauteile, durch einen Mikrocontroller oder durch beides realisiert werden.

An der Frontwandung 12 des Gehäuses 11 sind drei topfartige Vertiefungen 19 einstückig angeformt, deren ins Gehäuseinnere versetzter Boden jeweils einen zylindrischen Haltekanal 20 trägt, der wiederum einstückig angeformt ist. Dieser Haltekanal 20 verläuft senkrecht zur Frontwandung 12 und dient zur Aufnahme eines entsprechend geformten Verbindungselements 21 aus hartem elektrisch leitfähigem Kunststoffmaterial. Zur Ausbildung von federnden elastischen Eigenschaften ist der mittlere Bereich 22 dieses stabförmig ausgebildeten Verbindungselements 21 durch entsprechende randseitige schraubenförmige Ausnehmungen als Schraubenfeder ausgebildet. Alternativ hierzu könnte dieser Bereich auch eine andere Druckfederform aufweisen und zB. zickzackförmig ausgebildet sein. Dieses Verbindungselement 21 liegt mit seinem zum Gehäuseinnern hinweisenden Ende an einer Kontaktfläche der Leiterplatte 11 an und besitzt an seinem entgegengesetzten Ende ein scheibenförmiges Anlageelement 23, das einstückig angeformt ist. Es steht im unbelasteten Zustand gemäß Figur 1 nach außen über die Frontwandung 12 über. Wird das Gehäuse 10 an eine Abdeckplatte 24 eines zu steuernden elektrischen Geräts angelegt bzw. anmontiert, so wird das Verbindungselement 21 elastisch zusammengedrückt und dient als elektrische Verbindung zwischen der Kontaktfläche an der Leiterplatte 11 und der aus isolierendem Material bestehenden Abdeckplatte 24, die beispielsweise eine Glasplatte sein kann.

Zwischen dem Anlageende des Verbindungselements 21 an der Leiterplatte 11 und dem mittleren schraubenfederartigen Bereich 22 besitzt das Verbindungselement 21 noch einen ringnutartigen Bereich 25, in den ein ringförmiger Endbereich 26 des Haltekanals 20 eingreift. Nach dem Einstecken des Verbindungselements 21 in den Haltekanal 20 wird dadurch ein Herausfallen verhindert, und es ist eine gewisse Längsverschiebbarkeit im Haltekanal 20 dennoch gewährleistet.

Durch das elastische Zusammenpressen des Verbindungselements 21 im montierten Zustand erweitert sich dessen Durchmesser geringfügig und bewirkt eine Abdichtung des Haltekanals 20 und damit eine Abdichtung des Gehäuses 10 gegen Staub, Feuchtigkeit oder dergleichen. An der topfartigen Vertiefung 19, die zur Aufnahme des scheibenförmigen Anlageelements 23 des Verbindungselements 21 eine entsprechende Gestalt besitzt, ist zum Gehäuseinneren hin ein weiteres den Haltekanal 20 konzentrisch umgreifendes topfartiges Führungselement 27 einstückig angeformt, das nahezu bis zur Leiterplatte 11 reicht und dort eine Durchgangsöffnung zur Führung des Verbindungselements 21 besitzt.

Die Verbindungselemente 21 bilden jeweils einen wesentlichen Teil von drei berührungssensitiven Bedienungselementen 28 bis 30, wobei in den Schnittdarstellungen gemäß den Figuren 1 und 2 nur jeweils ein Bedienungselement 30 erkennbar ist, da die Bedienungselemente in dieser Ansicht hintereinander angeordnet sind. Die Abdeckplatte 24 kann zumindest an den entsprechenden Stellen durchsichtig ausgebildet sein, damit die Verbindungselemente 21 bzw. deren scheibenförmige Anlageelemente 23 erkennbar sind. Es ist jedoch auch möglich, entsprechende Markierungen oder Kennzeichnungen an den entsprechenden Stellen einer undurchsichtigen Abdeckplatte 24 vorzusehen. Entsprechend muss die Abdeckplatte 24 zumindest im Bereich des Displays 13 durchsichtig ausgebildet sein.

Die Zahl der Bedienungselemente 28 bis 30 ist selbstverständlich nicht auf die des Ausführungsbeispiels festgelegt, sondern es können vielmehr die jeweils benötigte Anzahl von Bedienungselementen für die jeweiligen Funktionen vorgesehen sein. Beim Ausführungsbeispiel kann das mittlere Bedienungselement 29 zum Aufrufen eines Bedienungsmenüs und die beiden äußeren Bedienungselemente 28 und 30 zur Weiterschaltung und zum Auslösen von Befehlen als Plustaste und Minustaste ausgebildet sein.

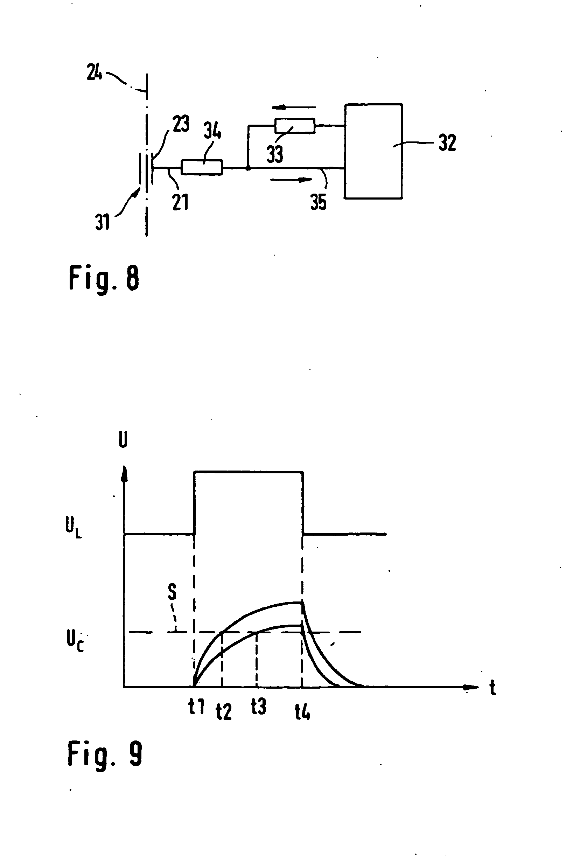

Im Folgenden soll die Wirkungsweise der berührungssensitiven Bedienungselemente 28 bis 30 anhand der Figuren 8 und 9 erläutert werden. Der scheibenförmige Anlagebereich 23 des Verbindungselements 21 bildet zusammen mit einem an der gegenüberliegenden Seite der Abdeckplatte 24 anliegenden Finger einer Bedienungsperson einen Kondensator 31. Liegt kein Finger an, so ist die Kapazität dieses Kondensators 31 deutlich geringer. Eine Ladestromquelle 32 dient zur Aufladung dieses Kondensators 31 über einen Ladewiderstand 33 und einen Schutzwiderstand 34. Die Ladestromquelle 32 kann beispielsweise durch einen Mikrocontroller realisiert oder durch einen solchen gesteuert werden und befindet sich auf der Leiterplatte 11. Gemäß Figur 9 erzeugt die Ladestromquelle 32 eine getaktete Ladespannung. Jeweils während einem solchen Taktsignal U_{L} wird der Kondensator 31 geladen und anschließend über einen parallel zum Ladewiderstand 33 geschalteten Entlandezweig 35 schnell entladen. Während des Anliegens der Ladespannung U_{L} baut sich die Kondensatorspannung Uc auf, wobei bei angelegtem Finger der Bedienungsperson und damit größerer Kapazität der Spannungsaufbau langsamer erfolgt im Gegensatz zu geringeren Kapazität bei nicht angelegtem Finger. Der Ladevorgang beginnt zum Zeitpunkt t1. Ohne angelegtem Finger wird eine Schwellspannung S bereits zum Zeitpunkt t2 erreicht, während diese Schwellspannung S bei angelegtem Finger erst zum Zeitpunkt t3 erreicht wird. Zum Zeitpunkt t4 erfolgt die Entladung. Durch Messen der Zeit bis zum Erreichen der Schwellspannung S kann der Mikrocontroller somit entscheiden, ob ein entsprechender Schaltvorgang ausgelöst werden soll oder nicht.

Die beschriebene Wirkungsweise der berührungssensitiven Bedienungselemente 28 bis 30 eignet sich besonders gut in Verbindung mit dem erfindungsgemäßen Steuergerät, allerdings können prinzipiell auch andere bekannte Funktionsprinzipien eingesetzt werden.

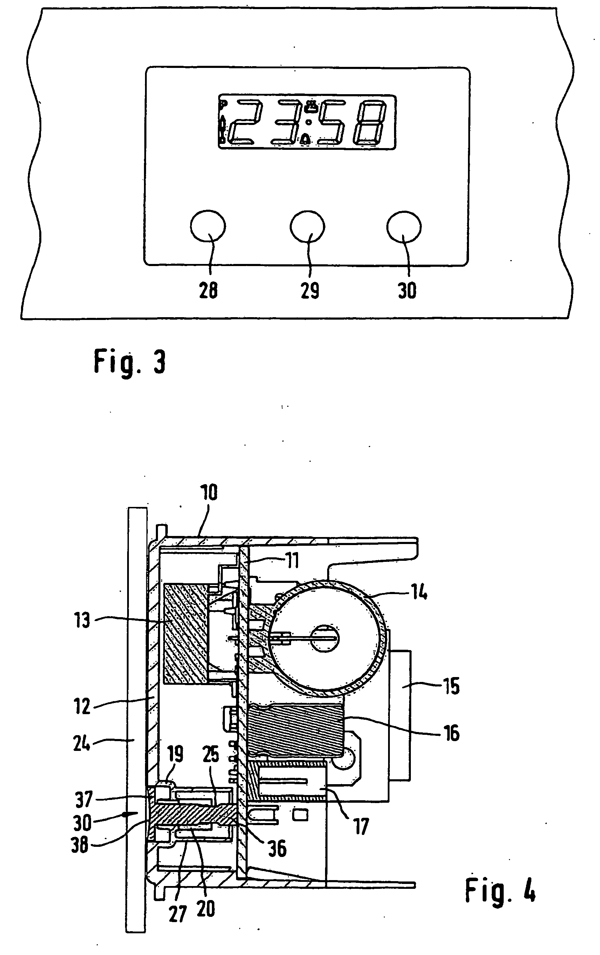

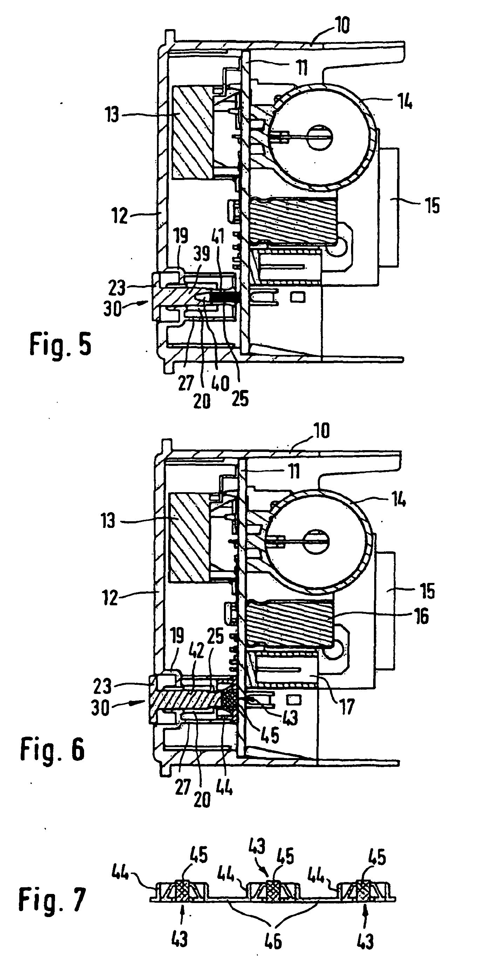

Das in Figur 4 dargestellte zweite Ausführungsbeispiel ist bis auf die andere Ausbildung der Verbindungselemente 36 mit dem ersten Ausführungsbeispiel, so dass auf eine nochmalige Beschreibung verzichtet werden kann und nur wesentlichere Bauteile mit den entsprechenden Bezugszeichen versehen sind. Dasselbe gilt auch für das dritte und vierte Ausführungsbeispiel gemäß den Figuren 5 und 6.

Die Verbindungselemente 36 bestehen aus weichelastischem, leitfähigem Kunststoffmaterial, beispielsweise aus leitfähigem Silikon, so dass der schraubenfederartige mittlere Bereich entfallen kann. Ein abgewandeltes scheibenförmiges Anlageelement 37 besitzt eine tellerartige bzw. konkave Vertiefung 38 zur Verbesserung des elastischen Anliegens an der Abdeckplatte 24. Auch dieses Verbindungselement besitzt wiederum einen entsprechenden ringnutartigen Bereich 25.

Beim dritten Ausführungsbeispiel gemäß Figur 5 sind Verbindungselemente 39 verwendet, die aus einem harten, leitfähigen Kunststoffmaterial oder aus Metall bestehen. In ein Sackloch 40 an der leiterplattenseitigen Stirnseite dieses Verbindungselements 39 ist eine Druckfeder 41 eingesetzt, die sich elastisch an der Kontaktfläche der Leiterplatte 11 abstützt und zum einen die elektrische Verbindung herstellt und zum anderen für die federnde Elastizität des Verbindungselements 39 sorgt.

Bei dem in Figur 6 dargestellten vierten Ausführungsbeispiel sind Verbindungselemente 42 vorgesehen, die aus leitfähigem harten Kunststoffmaterial oder aus Metall bestehen, und die sich jeweils zur Leiterplatte 11 hin an einem aus elastischem leitfähigem Kunststoffmaterial bestehenden Zwischenelement 43 abstützen und dieses Zwischenelement 43 dient somit zum einen wiederum zur elektrischen Verbindung und sorgt zum anderen für die erforderliche federnde Elastizität. Das Zwischenelement 43 kann dabei als loses Element ausgebildet sein oder am Verbindungselement 32 oder an der Kontaktfläche der Leiterplatte 11 befestigt sein. Es besitzt im Ausführungsbeispiel dargestellt, jedoch optional, einen rohrartigen Bereich 44, der einen zylindrischen Verbindungsbereich 45 zur elektrischen Verbindung konzentrisch umgibt. Dieser rohrartige Bereich 44 greift in das topfartige Führungselement 27 ein und wird elastisch an diesem gehalten, was zur Vereinfachung der Montage beiträgt.

Gemäß Figur 7 können alle Zwischenelemente 43 bandartig miteinander verbunden sein, und können somit gemeinsam zur Erleichterung der Montage in die Führungselemente 27 eingesetzt werden. Es muss selbstverständlich sichergestellt sein, dass die Zwischenelemente 43 untereinander elektrisch isoliert sind, beispielsweise dadurch, dass die bandartigen Verbindungsbereiche 46 aus elektrisch isolierendem Kunststoffmaterial bestehen.

In einer weiteren alternativen Ausgestaltung der Erfindung, die nicht gesondert dargestellt ist, kann der stabförmige Bereich der Verbindungselemente auch insgesamt als Druckfederelement ausgebildet sein, beispielsweise durch eine Zickzackform oder eine Schraubenfederform.

Gemäß den dargestellten und beschriebenen Ausführungsbeispielen liegt das Gehäuse 10 an der Abdeckplatte 24 direkt an bzw. ist an dieser anmontiert. Bei einer alternativen Ausführung kann das Gehäuse 10 auch beabstandet von der Abdeckplatte 24 positioniert sein, wobei die Abdeckplatte 24 und die Frontwandung 12 des Gehäuses 10 parallel zueinander angeordnet sind. In diesem Falle können die Vertiefungen 19 in der Frontwandung 12 entfallen, und es muss lediglich sichergestellt sein, dass sich die Verbindungselemente bis zur Abdeckplatte 24 erstrecken, so dass die Anlageelemente 23 bzw. 37 daran anliegen.

## Patentansprüche

1. Elektronisches Steuergerät für elektrische Geräte, mit einem Gehäuse (10), das wenigstens eine elektronische Bauelemente aufweisende Leiterplatte (11) enthält und mit einer ersten Seitenwandung (12) im Gebrauchszustand an einer isolierenden Abdeckplatte (24) anliegt oder beabstandet von dieser positioniert ist, und mit wenigstens einem berührungssensitiven kapazitiven Bedienungselement (28-30), das ein zwischen einer Kontaktfläche der Leiterplatte (11) und der Abdeckplatte (24) elastisch klemmendes elektrisch leitfähiges Verbindungselement (21, 36, 39, 42) besitzt, wobei die der Anlagefläche des Verbindungselements (21, 36, 39, 42) an der Abdeckplatte (24) gegenüberliegende Außenfläche der Abdeckplatte (24) die berührungssensitive Bedienungsfläche des Bedienungselements (28-30) bildet, **dadurch gekennzeichnet, dass** das Verbindungselement (21, 36, 39, 42) stabförmig ausgebildet ist und an seinem der Abdeckplatte (24) zugewandten Ende eine Anlagescheibe (23) aufweist, wobei der stabförmige Teil des Verbindungslements in einem Haltekanal (20) des Gehäuses, der zwischen der Leiterplatte (11) und der Abdeckplatte (24) verläuft, gehalten wird, und die der Abdeckplatte zugewandte Gehäusewand eine Aufnahme (19) für die Anlagescheibe (23) besitzt.

2. Steuergerät nach Anspruch 1, **dadurch gekennzeichnet, dass** das Verbindungselement (21; 36; 39; 42) im nicht an der Abdeckplatte (24) montierten Zustand im Haltekanal (20) längsverschiebbar ausgebildet ist.

3. Steuergerät nach Anspruch 1 oder 2, **dadurch gekennzeichnet, dass** das elastisch ausgebildete Verbindungselement (21; 36; 39; 42) aus leitfähigem Kunststoffmaterial besteht, insbesondere aus leitfähigem Silikon.

4. Steuergerät nach Anspruch 3, **dadurch gekennzeichnet, dass** das Verbindungselement (21) zur Erzielung der Elastizität wenigstens teilweise schraubenfederartig oder zickzackförmig ausgebildet ist.

5. Steuergerät nach Anspruch 1 oder 2, **dadurch gekennzeichnet, dass** das Verbindungselement (39; 42) einen stabförmigen Bereich aus einem harten leitfähigen Kunststoffmaterial oder aus Metall besitzt, der wenigstens an einem Ende mit einem federnden Anlagebereich versehen ist oder an einem solchen mündet, wobei dieser Anlagebereich als Druckfeder (41) oder als elastisches leitfähiges Kunststoffteil (43) ausgebildet ist.

6. Steuergerät nach Anspruch 5, **dadurch gekennzeichnet, dass** das elastische Kunststoffteil (43) zwischen dem stabförmigen Bereich des Verbindungselements (42) und der Kontaktfläche der Leiterplatte (11) angeordnet ist.

7. Steuergerät nach Anspruch 6, **dadurch gekennzeichnet, dass** mehrere elastisch leitfähige Kunststoffteile (43) für nebeneinander angeordnete Bedienungselemente (28 bis 30) über Verbindungsbereiche (46) aus nicht leitfähigem Kunststoffmaterial miteinander verbunden sind.

8. Steuergerät nach einem der vorhergehenden Ansprüche, **dadurch gekennzeichnet, dass** der stabförmige Bereich des Verbindungselements (21; 36; 39; 42) zylindrisch ausgebildet ist und vorzugsweise einen ringnutartigen Teilbereich (25) besitzt, in den ein Gegenbereich (46) des Haltekanals (20) eingreift.

9. Steuergerät nach Anspruch 1 oder 2, **dadurch gekennzeichnet, dass** das Verbindungselement als Druckfederelement ausgebildet ist und insbesondere eine Zickzackform besitzt.

10. Steuergerät nach einem der vorhergehenden Ansprüche, **dadurch gekennzeichnet, dass** der scheibenartige Anlagebereich (37) als elastischem Material besteht.

11. Steuergerät nach einem der vorhergehenden Ansprüche, **dadurch gekennzeichnet, dass** das im montierten Zustand elastisch zusammengepresste Verbindungselement (21; 36; 39; 42) im Haltekanal (20) zu dessen Abdichtung und dadurch zur Abdichtung des Gehäuses (10) vorgesehen ist.

12. Steuergerät nach einem der vorhergehenden Ansprüche, **dadurch gekennzeichnet, dass** der wenigstens eine Haltekanal (20) des Gehäuses (10) zur wahlweisen Aufnahme auch eines stabförmigen Auslöseelements für einen elektrischen Schalter ausgebildet ist, der insbesondere an der Leiterplatte (11) angeordnet ist.

13. Steuergerät nach einem der vorhergehenden Ansprüche, **gekennzeichnet durch** die Ausbildung als Zeitschaltgerät.

14. Steuergerät nach einem der vorhergehenden Ansprüche, **dadurch gekennzeichnet, dass** wenigstens drei Bedienungselemente (28 bis 30) vorgesehen sind, von denen eines (29) als Menütaste und die beiden anderen (28, 30) als Minus- und Plustaste ausgebildet sind.

15. Steuergerät nach einem der vorhergehenden Ansprüche, **dadurch gekennzeichnet, dass** der wenigstens eine Haltekanal (20) einstückig an das aus einem Kunststoffmaterial bestehenden Gehäuse (10) angeformt ist.

16. Steuergerät nach einem der vorhergehenden Ansprüche, **dadurch gekennzeichnet, dass** das einen Pol eines Kondensators (31) bildende Verbindungselement (21; 36; 39; 42) mit einer zyklisch eine Ladespanne (U_{L}) anlegenden Ladestromquelle (32) verbunden ist, wobei die jeweils erreichte und gemessene Kondensatorspannung (Uc) das Kriterium darstellt, ob ein Finger einer Bedienungsperson als zweiter Pol des Kondensators (31) an der Bedienungsfläche anliegt.

## Claims

1. Electronic control unit for electrical devices, with a casing (10) containing at least one printed circuit board (11) with electronic components and which in the operative state abuts with a first side wall (12) or is positioned with clearance from an insulating cover plate (24), and with at least one touch-sensitive capacitive operating element (28 - 30) which has an electrically conductive connection element (21, 36, 39, 42) which clamps elastically between a contact surface of the printed circuit board (11) and the cover plate (24), wherein the outer surface of the cover plate (24) opposite the contact surface of the connection element (21, 36, 39, 42) on the cover plate (24) forms the touch-sensitive operating surface of the operating element (28 - 30), **characterised in that** the connection element (21, 36, 39, 42) is bar-shaped and has a contact disc (23) at its end facing the cover plate (24), wherein the bar-shaped section of the connection element is held in a retaining channel (20) of the casing which runs between the printed circuit board (11) and the cover plate (24), and the casing wall facing the cover plate (24) has a receptacle (19) for the contact disc (23).

2. Control unit according to claim 1, **characterised in that** the connection element (21; 36; 39; 42), when not fitted to the cover plate (24), is able to slide longitudinally in the retaining channel (20).

3. Control unit according to claim 1 or 2, **characterised in that** the elastic connection element (21; 36; 39; 42) is made of conductive plastic material, in particular of conductive silicone.

4. Control unit according to claim 3, **characterised in that** the connection element (21) is at least partly in the form of a helical spring or is of zigzag shape to obtain elasticity.

5. Control unit according to claim 1 or 2, **characterised in that** the connection element (39; 42) has a bar-shaped section made of a rigid conductive plastic material or of metal, which is provided on at least one end with a sprung contact section or opens out to such, wherein this contact section is in the form of a compression spring (41) or an elastic conductive plastic component (43).

6. Control unit according to claim 5, **characterised in that** the elastic plastic component (43) is located between the bar-shaped section of the connection element (42) and the contact surface of the printed circuit board (11).

7. Control unit according to claim 6, **characterised in that** several elastic conductive plastic components (43) for adjacent operating elements (28 to 30) are connected to one another by connecting sections (46) of non-conductive plastic material.

8. Control unit according to any of the preceding claims, **characterised in that** the bar-shaped section of the connection element (21; 36; 39; 42) is cylindrical in shape and preferably has an annular slot-like section (25) in which a mating section (46) of the retaining channel (20) engages.

9. Control unit according to claim 1 or 2, **characterised in that** the connection element is in the form of a compression spring element and in particular has a zigzag shape.

10. Control unit according to any of the preceding claims, **characterised in that** the disc-shaped contact section (37) is made of elastic material.

11. Control unit according to any of the preceding claims, **characterised in that** the connection element (21; 36; 39; 42) which is elastically compressed in the installed state is provided in the retaining channel (20) for sealing of the latter and by this means for sealing of the casing (10).

12. Control unit according to any of the preceding claims, **characterised in that** the retaining channel or channels (20) of the casing (10) is or are also provided for optional accommodation of a bar-shaped actuating element for an electrical switch, which is located in particular on the printed circuit board (11).

13. Control unit according to any of the preceding claims, **characterised by** its design as a preset timer.

14. Control unit according to any of the preceding claims, **characterised in that** at least three operating elements (28 to 30) are provided, of which one (29) is in the form of a menu button and the other two (28, 30) are minus and plus buttons.

15. Control unit according to any of the preceding claims, **characterised in that** the retaining channel or channels (20) is or are moulded integrally to the casing (10) made of plastic material.

16. Control unit according to any of the preceding claims, **characterised in that** one terminal of a connection element (21; 36; 39; 42) forming a capacitor (31) is connected to a charging current source (32) applying a cyclic charging voltage (U_{L}), wherein the respectively obtained and measured capacitor voltage (U_{c}) represents the criterion to determine whether a finger of an operating person is in contact with the operating surface as the second pole of the capacitor (31).

## Revendications

1. Appareil de commande électronique pour des appareillages électriques, avec un boîtier (10) qui contient au moins un circuit imprimé (11) présentant des composants électroniques et qui, en état d'utilisation, s'appuie avec une première paroi (12) contre une plaque de recouvrement isolante (24) ou est positionné à distance de celle-ci, et avec au moins un élément d'utilisation (28-30) capacitif sensible au contact, qui possède un élément de jonction conducteur électrique (21, 36, 39, 42) se coinçant élastiquement entre une surface de contact du circuit imprimé (11) et la plaque de recouvrement (24), dans lequel la face extérieure de la plaque de recouvrement (24) opposée à la surface d'appui de l'élément de jonction (21, 36, 39, 42) au niveau de la plaque de recouvrement (24) forme la surface d'utilisation sensible au contact de l'élément de commande (28-30), **caractérisé en ce que** l'élément de jonction (21, 36, 39, 42) est réalisé en forme de barreau et présente sur son extrémité tournée vers la plaque de recouvrement (24) une plaque d'appui (23), dans lequel la partie en forme de barreau de l'élément de jonction est tenue dans un canal de maintien (20) du boîtier qui s'étend entre le circuit imprimé (11) et la plaque de recouvrement (24), et la paroi de boîtier tournée vers la plaque de recouvrement possède un logement (19) pour la plaque d'appui (23).

2. Dispositif de commande selon la revendication 1, **caractérisé en ce que** l'élément de jonction (21, 36, 39, 42) est conformé mobile longitudinalement dans le canal de maintien (20) à l'état non monté sur la plaque de recouvrement (24).

3. Dispositif de commande selon la revendication 1 ou 2, **caractérisé en ce que** l'élément de jonction (21, 36, 39, 42) réalisé élastique est composé d'un matériau synthétique conducteur, en particulier de silicone conductrice.

4. Dispositif de commande selon la revendication 3, **caractérisé en ce que**, pour obtenir l'élasticité, l'élément de jonction (21) est réalisé au moins partiellement en forme de ressort hélicoïdal ou en forme de zigzag.

5. Dispositif de commande selon la revendication 1 ou 2, **caractérisé en ce que** l'élément de jonction (39, 42) possède une zone en forme de barreau constituée d'un matériau synthétique conducteur dur ou d'un métal, qui est muni, au moins à une extrémité, d'une zone d'appui élastique ou débouche sur une telle zone, cette zone d'appui étant conformée en ressort de pression (41) ou en partie conductrice élastique (43) en matériau synthétique.

6. Dispositif de commande selon la revendication 5, **caractérisé en ce que** la partie élastique (43) en matériau synthétique est placée entre la zone en forme de barreau de l'élément de jonction (42) et la surface de contact du circuit imprimé (11).

7. Dispositif de commande selon la revendication 6, **caractérisé en ce que** plusieurs parties conductrices élastiques (43) en matériau synthétique destinées à des éléments d'utilisation (28 à 30) juxtaposés sont reliées entre elles par des zones de jonction (46) constituées d'un matériau synthétique non conducteur.

8. Dispositif de commande selon l'une des revendications précédentes, **caractérisé en ce que** la zone en forme de barreau de l'élément de jonction (21, 36, 39, 42) est réalisée cylindrique et possède de préférence une zone secondaire (25) en forme de rainure annulaire, dans laquelle s'engage une contre-partie (46) du canal de maintien (20).

9. Dispositif de commande selon la revendication 1 ou 2, **caractérisé en ce que** l'élément de jonction est conformé en élément à ressort de pression et possède en particulier une forme en zigzag.

10. Dispositif de commande selon l'une des revendications précédentes, **caractérisé en ce que** la zone d'appui (37) en forme de plaque est composée d'un matériau élastique.

11. Dispositif de commande selon l'une des revendications précédentes, **caractérisé en ce que** l'élément de jonction (21, 36, 39, 42) comprimé élastiquement à l'état monté est prévu dans le canal de maintien (10) pour son étanchéité et est ainsi prévu pour rendre le boîtier (10) hermétique.

12. Dispositif de commande selon l'une des revendications précédentes, **caractérisé en ce que** le canal de maintien (20) au nombre d'au moins un du boîtier (10) est conformé pour recevoir au choix également un élément de déclenchement en forme de barreau pour un commutateur électrique, qui est placé en particulier sur le circuit imprimé (11).

13. Dispositif de commande selon l'une des revendications précédentes, **caractérisé par** sa conformation en commutateur temporisé.

14. Dispositif de commande selon l'une des revendications précédentes, **caractérisé en ce qu'**au moins trois éléments d'utilisation (28 à 30) sont prévus, dont l'un (29) est conformé en touche de menu et les deux autres (28, 30) en touche Moins et Plus.

15. Dispositif de commande selon l'une des revendications précédentes, **caractérisé en ce que** le canal de maintien (20) au nombre d'au moins un est rapporté d'un seul tenant sur le boîtier (10) constitué d'un matériau synthétique.

16. Dispositif de commande selon l'une des revendications précédentes, **caractérisé en ce que** l'élément de jonction (21, 36, 39, 42) formant un pôle d'un condensateur (31) est relié avec une source de courant de charge (32) appliquant de manière cyclique une tension de charge (U_{L}), la tension de condensateur (U_{c}) atteinte et mesurée à chaque fois constituant le critère déterminant si un doigt d'un opérateur servant de deuxième pôle du condensateur (31) est appliqué sur la surface d'utilisation.
